# EUROPEAN PATENT SPECIFICATION

(11) **EP 3 476 187 B1**
(45) Date of publication and mention of the grant of the patent: **03.06.2020**
(21) Application number: 16734268.2
(22) Date of filing: 28.06.2016
(51) Int. Cl.: H05K 7/20, H02M 7/00

(54) **CELL MODULE FOR MODULAR CONVERTER**
ZELLENMODUL FÜR MODULAREN UMRICHTER
MODULE DE CELLULE POUR CONVERTISSEUR MODULAIRE

(43) Date of publication of application: 01.05.2019
(73) Proprietor: ABB Schweiz AG, 5400 Baden (CH)
(72) Inventor: DE-CANDIDO, Erika, 5400 Baden (CH); GARDONI, Irene, 5417 Untersiggenthal (CH); ØDEGÅRD, Bjørn, 5300 Turgi (CH); STEINKE, Jürgen, 79774 Albbruck (DE)
(74) Representative: Kransell & Wennborg KB
(86) International application number: PCT/EP2016/065006
(87) International publication number: WO 2018/001463

(56) References cited:
- EP-A1- 1 750 360
- WO-A1-2014/048680
- DE-A1-102011 006 988
- US-B1- 8 436 246

## Description

### Technical Field

The present disclosure generally relates to a cell module for a modular converter. In particular, a cell module for a modular converter comprising at least one connection member of electrically conductive material inside an enclosure of the cell module and a modular converter are provided.

### Background

Modular types of converters like modular multilevel converters (MMC's) allow to build converters with much higher voltage levels than the internal potential levels seen within these modules. Modular converter topologies like modular multilevel converters use switching cells operating at a certain voltage level. The switching cells are series connected to increase the operating voltage between converter terminals. With respect to insulation, this results in a requirement determined by the cell DC-voltage on the insulation inside the mechanical module. The insulation to ground is on the other hand determined by the maximum system voltage which shall be achieved at the converter terminals. These requirements can be much stronger than those inside the cell module. In order to guarantee a sufficient useful lifetime of industrial equipment, the design with respect to insulation distances and material has to be done in a way to avoid partial discharge for the regular equipment operation. Partial discharge occurs as soon as a certain electrical field strength is exceeded, depending on the insulation material.

High power modules are often cooled by deionized water to achieve a compact design. In this case, in addition to signal cables, also conduits of the cooling circuit connect the modules to other equipment on ground potential. In order to avoid partial discharges, it is known to use isolating material for the conduits and/or for the connections between the conduits and the modules. Some prior art cell modules are designed such that the distances between the water conducting isolating tubes and metallic parts of the cell module are extended to lower the electrical field strength to avoid partial discharges.

WO 2014048680 A1 discloses an electric insulating compound conduit for guiding a dielectric cooling fluid for cooling power electronics. The compound conduit comprises two electrically conductive pipe sections, and an electrically insulating conduit section of dielectric material connecting the pipe sections. End sections of the two pipe sections are embedded in the insulating material of the insulating conduit section such that when the pipe sections are on different electrical potentials, a region of the highest field strength between the pipe sections is located inside the dielectric material of the electrically insulating conduit section.

### Summary

For cell modules cooled with deionized water in conduits passing through a metallic surface, problems may occur due to the conductivity of the cooling water. Although the conductivity of the deionized water may be low, it is much higher than that of the isolating material of the conduit in which it is transported. The water content of the conduit connecting a metallic part in the cell module and a grounded part (or a point between the metallic part in the cell module and the grounded part) acts like a resistor. The electrical potential of the deionized water inside the conduit decreases between the metallic part in the cell module and the grounded part. Therefore, if a conduit of isolating material is connected to a metallic connection point inside the cell module, the electrical potential inside the deionized water can be much closer to ground potential when passing through the surface of the cell module than the electrical potential of the cell module. As a consequence, a high electrical potential difference might occur between the deionized water and the cell module structure with the risk of causing partial discharges.

Moreover, for prior art cell modules designed such that the distances between the water conducting isolating tubes and metallic parts of the cell module are extended to lower the electrical field strength to avoid partial discharges, the required distances between the isolating tubes and metallic parts of the cell module might be quite long. This is not only a problem for the compactness of the cell module, but the shielding effect of the metallic enclosure of the cell module for all devices inside the cell module with respect to undesired electrical fields resulting from other equipment sources might be reduced. A further disadvantage of these types of prior art cell modules is that the conduits have to be guided accurately through the cell module by isolating fixations.

One object of the present disclosure is to provide a cell module with an extended lifetime.

A further object of the present disclosure is to provide a cell module with a reduced risk for partial discharges.

A further object of the present disclosure is to provide a cell module having a compact, simple and/or cheap design.

According to one aspect, there is provided a cell module for a modular converter, the cell module comprising an enclosure having a wall section of electrically conductive material and an opening in the wall section; at least one interior cooling conduit for distributing a dielectric cooling fluid to and/or from an electronic component arranged within the enclosure; at least one exterior cooling conduit of dielectric material for delivering the dielectric cooling fluid to or from a region outside of the enclosure; and at least one connection member of electrically conductive material connecting the at least one interior cooling conduit to a respective exterior cooling conduit to establish a fluid connection between the electronic component and the region outside of the enclosure through the opening; wherein the at least one connection member and the wall section are at the same electrical potential; and wherein the at least one connection member is provided inside of and close to the wall section of the enclosure.

Due to the provision of the connection member inside of and close to the wall section of the enclosure, there is only a small electrical potential difference between the wall section of the enclosure and the dielectric cooling fluid inside the at least one exterior cooling circuit adjacent to the wall section. Thereby, the distance between the at least one exterior cooling conduit and the wall section of the enclosure can be dramatically reduced and the need for expensive isolation fixation material can be avoided or mitigated. Moreover, the design of the cell module can be made more compact.

The enclosure may comprise several walls to form a generally box shaped appearance. Not only the wall section, but all walls of the enclosure may be made of electrically conductive material, e.g. metal. The enclosure may comprise a plurality of receiving rooms, or receiving sections, each of which being designed for receiving one or more electronic component. The enclosure may alternatively be referred to as a cabinet or casing throughout the present disclosure.

The wall section may be constituted by a wall or by a part of a wall of the enclosure. The wall section may have a substantially flat appearance.

According to one variant, the cell module comprises two exterior cooling conduits, e.g. an inlet exterior cooling conduit and an outlet exterior cooling conduit. The two exterior cooling conduits may be enclosed by the opening in the wall section. The inlet exterior cooling conduit may be fluidly connected to an inlet flow line of a cooling system and the outlet exterior cooling conduit may be fluidly connected to an outlet flow line of the cooling system.

The two exterior cooling conduits may be connected to a respective of two interior cooling conduits by means of two connection members or by means or a joint connection member. The inlet exterior cooling conduit may be connected to an inlet interior cooling conduit by means of an inlet connection member and the outlet exterior cooling conduit may be connected to the outlet interior cooling conduit by means of an outlet connection member. The inlet interior cooling conduit and the outlet interior cooling conduit may be constituted by two sections of the same conduit, i.e. by a section upstream of the electronic component to be cooled and a section downstream of the electronic component, respectively.

Throughout the present disclosure, the terminology "inside" and "outside" refers to a position closer to and farther away from, respectively, a position for the electronic component within the cell module. A region outside of the enclosure as referred to herein may for example be constituted by a junction between the at least one exterior cooling conduit and a respective inlet flow line or outlet flow line.

The at least one connection member may for example be made of metal and/or may have a substantially cylindrical appearance. The at least one connection member may be positioned partly between the at least one interior cooling conduit and the respective exterior cooling conduit, along an axial direction of the connection member. The at least one connection member may circumferentially enclose the exterior cooling conduit. Furthermore, the at least one connection member may be in electrical contact with the wall section of the enclosure, for example via an interior support structure of electrically conductive material.

The dielectric cooling fluid may be constituted by various types of cooling fluids of low electrical conductivity. For example, the dielectric cooling fluid may be constituted by deionized water.

The at least one exterior cooling conduit may be constituted by various types of dielectric materials and may be rigid or flexible. The exterior cooling conduit may alternatively be referred to as a tube, hose or isolating water guide.

An outer surface of the at least one connection member may be substantially flush with an interior surface of the wall section. For example, a distance between the outer surface of the at least one connection member and the interior surface of the wall section may be less than 50 mm, such as less than 20 mm, such as less than 5 mm, including 0 mm.

The outer surface of the at least one connection member may have a flat appearance and may be substantially parallel with the interior surface of the wall section. In case the connection member has a cylindrical appearance, the outer surface may be constituted by one end side of the cylinder. Throughout the present disclosure, a substantially perpendicular/parallel relationship includes a perfectly perpendicular/parallel relationship as well as deviations from a perfectly perpendicular/parallel relationship with up to 5%, such as up to 2%.

The at least one exterior cooling conduit may comprise a substantially straight section connected to the connection member. For example, in case the cell module comprises two exterior cooling conduits, a substantially straight section of an inlet exterior cooling conduit may be connected between an inlet connection member and a junction of an inlet flow line and a substantially straight section of an outlet exterior cooling conduit may be connected between an outlet connection member and a junction of an outlet flow line. The substantially straight section of the at least one exterior cooling conduit may be substantially perpendicular to the wall section.

A distance between an outer surface of the at least one connection member and an interior surface of the wall section may be less than 10% of the length of the substantially straight section of the at least one exterior cooling conduit, such as less than 5%, such as less than 2%, such as less than 1%.

The at least one interior cooling conduit may be made of an electrically conductive material and may be electrically conductively connected to the enclosure. For example, the at least one interior cooling conduit may be constituted by a metallic tube.

If the cell module comprises an interior support structure, the at least one interior cooling conduit may be made of an electrically conductive material and may be electrically conductively connected to the interior support structure. For example, the at least one interior cooling conduit may be in mechanical contact with the interior support structure.

The at least one connection member may be constituted by an end section of the respective interior cooling conduit. The at least one connection member may thus be integrally formed with one or more interior cooling conduits.

The at least one exterior cooling conduit may be constituted by two exterior cooling conduits enclosed by the opening in the wall section. Alternatively, a dedicated opening may be associated with each exterior cooling conduit. Thus, the cell module may comprise more than one opening associated with an exterior cooling conduit, either in the same wall section or in different wall sections of the enclosure.

The wall section of the enclosure may be constituted by sheet metal. In case the enclosure has a box shaped appearance, several walls may be constituted by sheet metal. The walls may for example be welded together or folded from a unitary piece of sheet metal.

The opening in the wall section may be delimited by one or more folds of the sheet metal. Each fold may comprise one or more curved profiles or bends. Each curved profile in turn may have a generally arc shaped appearance. For example, the one or more folds may be constituted by a continuous bend having an angular extension of approximately 180°. Alternatively, each fold may comprise two bends of approximately 90° and an interconnecting straight portion.

The opening may be established by cutting and folding the sheet metal inwardly. It is possible to cut and fold the sheet material in this manner without removing any material.

The cell module may further comprise an electronic component arranged within the enclosure. The electronic component may be constituted by a converter cell. The cell module may comprise at least two electronic components arranged within the enclosure.

According to a further aspect, there is provided a modular converter comprising a plurality of cell modules according to the present disclosure.

### Brief Description of the Drawings

Further details, advantages and aspects of the present disclosure will become apparent from the following embodiments taken in conjunction with the drawings, wherein:
- Fig. 1:: schematically represents a front view of a cell module;
- Fig. 2:: schematically represents a front view of a further cell module;
- Fig. 3:: schematically represents an enlarged front view of a wall section; and
- Fig. 4:: schematically represents a top view of the wall section in Fig. 3.

### Detailed Description

In the following, a cell module for a modular converter comprising at least one connection member of electrically conductive material inside an enclosure of the cell module and a modular converter will be described. The same reference numerals will be used to denote the same or similar structural features.

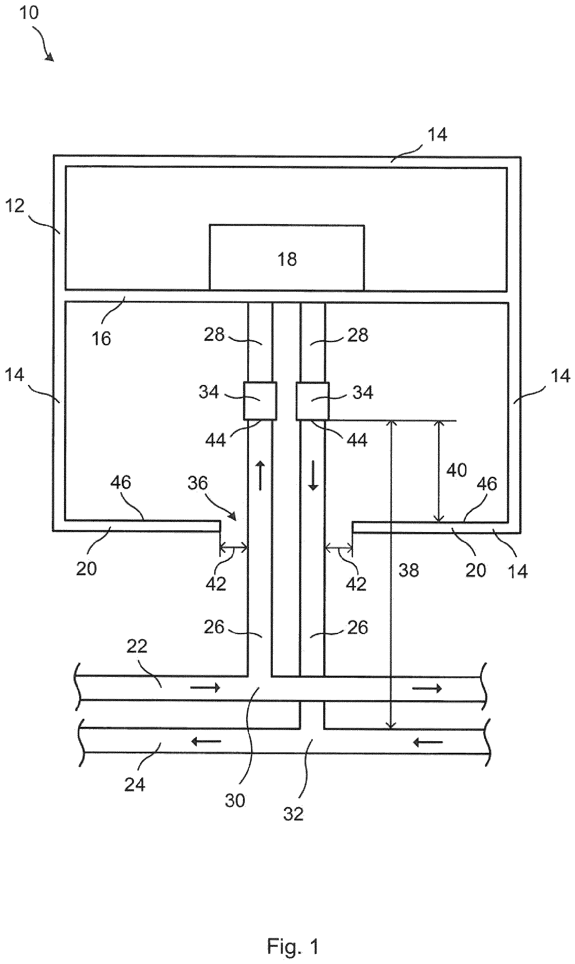

Fig. 1 schematically represents a front view of a cell module 10. The cell module 10 comprises an enclosure 12 of a generally box shaped appearance. The outer structure of the enclosure 12 is made of walls 14 of sheet metal. The enclosure 12 further comprises an interior support structure 16 in the form of a metal profile for supporting an electronic component 18. The electronic component 18 may for example be constituted by a converter cell.

One or several electronic components 18 may be provided within the enclosure 12. The cell module 10 constitutes a part of a modular converter (not shown) comprising a plurality of cell modules 10.

The lower wall 14 in Fig. 1 constitutes a wall section 20. However, the wall section 20 may alternatively be constituted by only a part of the lower wall 14. As can be seen in Fig. 1, the wall section 20 has a flat appearance.

Fig. 1 further shows a part of a cooling system for providing a dielectric cooling fluid to cool the electronic component 18 comprising an inlet flow line 22, an outlet flow line 24, two exterior cooling conduits 26 of dielectric material and two interior cooling conduits 28 of electrically conductive material. An inlet exterior cooling conduit 26 is connected to the inlet flow line 22 at a junction 30 and is fluidly connected to the inlet interior cooling conduit 28 (i.e. upstream of the electronic component 18). An outlet exterior cooling conduit 26 is in fluid connection with the outlet interior cooling conduit 28 (i.e. downstream of the electronic component 18) and is connected to the outlet flow line 24 at a junction 32.

In Fig. 1, each exterior cooling conduit 26 comprises a substantially straight section substantially perpendicular to the wall section 20. The provision of, for example, bends in the exterior cooling conduits 26 is however possible outside of (i.e. below) the straight sections, e.g. in proximity to the respective junction 30, 32.

The cell module 10 further comprises two connection members 34 of electrically conductive material connecting the exterior cooling conduits 26 and the respective interior cooling conduits 28 to provide the fluid connections. The exterior cooling conduits 26 pass through an opening 36 in the wall section 20 and into the interior of the enclosure 12. In Fig. 1, the two connection members 34 and the wall section 20 are at the same electrical potential and the inlet flow line 22 and the outlet flow line 24 are at ground potential.

Although the electric conductivity of the dielectric fluid is quite low, it is much higher than that of the insulating material of the exterior cooling conduits 26 in which it is transported. The dielectric fluid content within the exterior cooling conduits 26 is thus connected between a component on ground potential (i.e. the inlet flow line 22 or the outlet flow line 24) and a component on a different potential (i.e. the connection member 34 on high electrical potential). This fluid content therefore acts as a resistor.

For example, if the outlet exterior cooling conduit 26 has a constant diameter, the electrical potential between the outlet connection member 34 and the grounded junction 32 decreases linearly along the distance 38. With varying diameter (or other cross-sectional shapes) of the exterior cooling conduit 26, the distribution of electrical potential is not linear, but the phenomenon is not generally changed. Since the connection members 34 are provided quite far inside the enclosure 12, as indicated by distance 40, the electrical potential of the dielectric cooling fluid can be much closer to ground potential when passing through the opening 36 than the electrical potential of the wall section 20. Thus, a high potential difference can occur between the dielectric cooling fluid and the wall section 20 with the risk of causing partial discharges.

In order to avoid or mitigate this risk for partial discharges, a distance 42 between each exterior cooling conduit 26 and the wall section 20 has to be large and/or expensive insulation fixation material has to be provided.

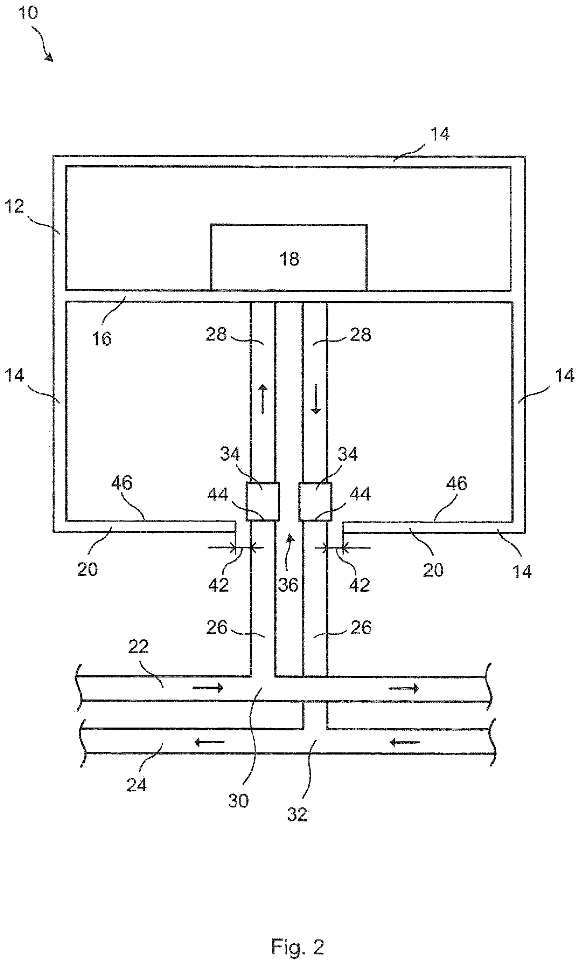

Fig. 2 schematically represents a front view of a further cell module 10. Mainly differences with respect to Fig. 1 will be described. In Fig. 2, the connection members 34 are still provided inside of the wall section 20 of the enclosure 12, but are provided significantly closer to the wall section 20 in comparison with Fig. 1. Therefore, the electrical potential of the dielectric cooling fluid inside the exterior cooling conduits 26 when passing through the opening 36 is much closer to the electrical potential of the wall section 20. As a consequence, the risk for partial discharges is reduced and the distance 42 between the wall section 20 and the respective exterior cooling conduits 26 can be reduced.

The connection members 34 in Fig. 2 are made of an electrically conductive material (e.g. metal) and each has a substantially cylindrical appearance. The interior cooling conduits 28 are also extended in order to provide the electrical connection between the connection members 34 and the wall section 20 (via the interior support structure 16). Each connection member 34 comprises a substantially flat outer surface 44 (lower surface in Fig. 2) that is substantially parallel with the wall section 20.

By comparing Figs. 1 and 2, it can be seen that the distance 40 between the outer surface 44 of the connection members 34 and an interior surface 46 of the wall section 20 is significantly reduced in Fig. 2. This distance in Fig. 2 (not denoted) may be less than 50 mm, such as less than 20 mm, such as less than 5 mm, including 0 mm. The distance may vary depending on the radius of the connection members 34. In case this distance is 0 mm, the outer surface 44 of the connection member 34 will still be provided inside an exterior surface of the wall section 20 due to the thickness of the wall section 20.

Moreover, a distance (c.f. the distance 40 in Fig. 1, not denoted in Fig. 2) between the outer surface 44 of each connection member 34 and the interior surface 46 of the wall section 20 may be less than 10% of the distance (c.f. the distance 38 in Fig. 1, not denoted in Fig. 2) of the substantially straight section of each exterior cooling conduit 26.

Although the connection members 34 in Fig. 2 are attached to the respective interior cooling conduit 28, these components may be integrally formed (e.g. of metal).

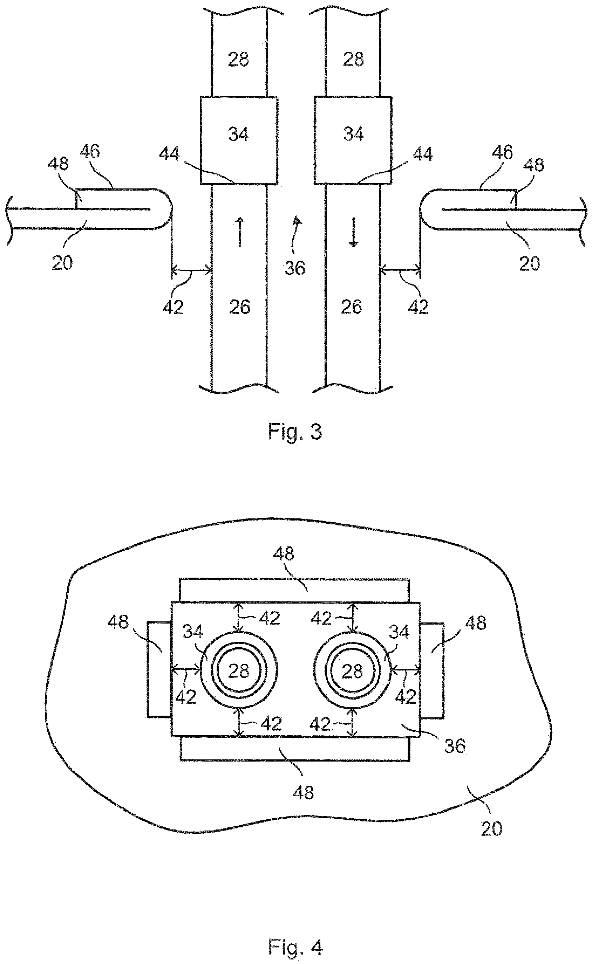

Figs. 3 and 4 schematically represent enlarged views (front view and top view, respectively) of a wall section 20 that has been modified with respect to Fig. 2.

The electrical field strength is on the one hand determined by differences in electrical potential and the distance between the conducting materials having the electrical potential difference, but on the other hand also by the surface structure of the conducting materials, which are on different electrical potentials. The lowest field strength at a given distance and potential difference is achieved with two parallel conducting plates with absolutely flat surface (neglecting edge effects). The highest electrical field strength is seen with the same distance and potential difference having two tips of needles pointing to each other.

Although the potential difference between the dielectric cooling fluid within the exterior cooling conduits 26 and the wall section 20 can be kept quite small with a cell module 10 according to Fig. 2, sharp edges of the wall section 20 close to the exterior cooling conduit 26 might increase the electrical field. Therefore, as shown in Figs. 3 and 4, the opening 36 in the wall section 20 may be delimited by one or more folds 48 of the sheet metal. The folds 48 are provided by cutting the sheet metal that forms or will form the wall section 20 and folding end portions of the sheet metal inwardly into the cell module 10 (upwardly in Fig. 3). Thus, the whole area of the opening 36 is not cut out. Thereby, a natural radius is created in the wall section 20 closest to the exterior cooling conduits 26 which reduces the electrical field strength. In this manner, the risk for partial discharges at the opening 36 may be further reduced and an even smaller distance 42 and an even more compact design of the cell module 10 are consequently allowed.

In Figs. 3 and 4, the opening 36 has a generally rectangular appearance delimited by four folds 48. Each fold 48 comprises a continuous bend having an angular extension of approximately 180°. Each fold 48 may alternatively comprise two bends, each of approximately 90°, and an intermediate straight portion.

While the present disclosure has been described with reference to exemplary embodiments, it will be appreciated that, for example, the dimensions of the parts may be varied as needed. Accordingly, it is intended that the present invention may be limited only by the scope of the claims appended hereto.

## Claims

1. Cell module (10) for a modular converter, the cell module (10) comprising:
- an enclosure (12) having a wall section (20) of electrically conductive material and an opening (36) in the wall section (20);
- at least one interior cooling conduit (28) for distributing a dielectric cooling fluid to and/or from an electronic component (18) arranged within the enclosure (12);
- at least one exterior cooling conduit (26) of dielectric material for delivering the dielectric cooling fluid to or from a region outside of the enclosure (12); and
- at least one connection member (34) of electrically conductive material connecting the at least one interior cooling conduit (28) to a respective exterior cooling conduit (26) to establish a fluid connection between the electronic component (18) and the region outside of the enclosure (12) through the opening (36);
wherein the at least one connection member (34) and the wall section (20) are at the same electrical potential; and
wherein the at least one connection member (34) is provided inside of and close to the wall section (20) of the enclosure (12).

2. The cell module (10) according to claim 1, wherein an outer surface (44) of the at least one connection member (34) is substantially flush with an interior surface (46) of the wall section (20).

3. The cell module (10) according to claim 1 or 2, wherein the at least one exterior cooling conduit (26) comprises a substantially straight section connected to the connection member (34).

4. The cell module (10) according to claim 3, wherein a distance (40) between an outer surface (44) of the at least one connection member (34) and an interior surface (46) of the wall section (20) is less than 10% of the length (38) of the substantially straight section of the at least one exterior cooling conduit (26).

5. The cell module (10) according to any of the preceding claims, wherein the at least one interior cooling conduit (28) is made of an electrically conductive material and is electrically conductively connected to the enclosure (12).

6. The cell module (10) according to claim 5, further comprising an interior support structure (16), wherein the at least one interior cooling conduit (28) is made of an electrically conductive material and is electrically conductively connected to the interior support structure (16).

7. The cell module (10) according to claim 5 or 6, wherein the at least one connection member (34) is constituted by an end section of the respective interior cooling conduit (28).

8. The cell module (10) according to any of the preceding claims, wherein the at least one exterior cooling conduit (26) is constituted by two exterior cooling conduits (26) enclosed by the opening (36) in the wall section (20).

9. The cell module (10) according to any of the preceding claims, wherein the wall section (20) is constituted by sheet metal.

10. The cell module (10) according to claim 9, wherein the opening (36) is delimited by one or more folds (48) of the sheet metal.

11. The cell module (10) according to claim 9 or 10, wherein the opening (36) is established by cutting and folding the sheet metal inwardly.

12. The cell module (10) according to any of the preceding claims, further comprising an electronic component (18) arranged within the enclosure (12).

13. The cell module (10) according to claim 12, wherein the electronic component (18) is constituted by a converter cell.

14. The cell module (10) according to claim 12 or 13, wherein the cell module (10) comprises at least two electronic components (18) arranged within the enclosure (12).

15. A modular converter comprising a plurality of cell modules (10) according to any of the preceding claims.

## Patentansprüche

1. Zellenmodul (10) für einen modularen Umrichter, wobei das Zellenmodul (10) umfasst:
- ein Gehäuse (12), das einen Wandabschnitt (20) aus einem elektrisch leitfähigen Material und eine Öffnung (36) in dem Wandabschnitt (20) aufweist;
- mindestens eine interne Kühlleitung (28), um ein dielektrisches Kühlmedium an eine elektronische Komponente (18), die innerhalb des Gehäuses (12) angeordnet ist, zu verteilen und/oder von derselben zu empfangen;
- mindestens eine externe Kühlleitung (26) aus einem dielektrischen Material, um das dielektrische Kühlmedium in ein Gebiet außerhalb des Gehäuses (12) zu übergeben oder aus diesem zu empfangen; und
- mindestens ein Verbindungselement (34) aus einem elektrisch leitfähigen Material, das die mindestens eine interne Kühlleitung (28) mit einer entsprechenden externen Kühlleitung (26) verbindet, um durch die Öffnung (36) eine Strömungsverbindung zwischen der elektronischen Komponente (18) und dem Gebiet außerhalb des Gehäuses (12) einzurichten;
wobei das mindestens ein Verbindungselement (34) und der Wandabschnitt (20) auf dem gleichen elektrischen Potential liegen und
wobei das mindestens ein Verbindungselement (34) innerhalb und in der Nähe des Wandabschnitts (20) des Gehäuses (12) bereitgestellt wird.

2. Zellenmodul (10) nach Anspruch 1, wobei eine Außenfläche (44) des mindestens einen Verbindungselements (34) im Wesentlichen bündig mit einer Innenfläche (46) des Wandabschnitts (20) ist.

3. Zellenmodul (10) nach Anspruch 1 oder 2, wobei die mindestens eine externe Kühlleitung (26) einen im Wesentlichen geraden Abschnitt umfasst, der mit dem Verbindungselement (34) verbunden ist.

4. Zellenmodul (10) nach Anspruch 3, wobei ein Abstand (40) zwischen der Außenfläche (44) des mindestens einen Verbindungselements (34) und einer Innenfläche (46) des Wandabschnitts (20) kleiner als 10 % der Länge (38) des im Wesentlichen geraden Abschnitts der mindestens einen externen Kühlleitung (26) ist.

5. Zellenmodul (10) nach einem der vorhergehenden Ansprüche, wobei die mindestens eine interne Kühlleitung (28) aus einem elektrisch leitfähigen Material hergestellt ist und elektrisch leitfähig mit dem Gehäuse (12) verbunden ist.

6. Zellenmodul (10) nach Anspruch 5, das außerdem eine interne Trägerstruktur (16) umfasst, wobei die mindestens eine interne Kühlleitung (28) aus einem elektrisch leitfähigen Material hergestellt ist und elektrisch leitfähig mit der internen Trägerstruktur (16) verbunden ist.

7. Zellenmodul (10) nach Anspruch 5 oder 6, wobei das mindestens eine Verbindungselement (34) aus einem Endabschnitt der entsprechenden internen Kühlleitung (28) besteht.

8. Zellenmodul (10) nach einem der vorhergehenden Ansprüche, wobei die mindestens eine externe Kühlleitung (26) aus zwei externen Kühlleitungen (26) besteht, die durch die Öffnung (36) in dem Wandabschnitt (20) umschlossen werden.

9. Zellenmodul (10) nach einem der vorhergehenden Ansprüche, wobei der Wandabschnitt (20) aus einem Metallblech besteht.

10. Zellenmodul (10) nach Anspruch 9, wobei die Öffnung (36) durch eine oder mehrere Falzen (48) des Metallblechs begrenzt wird.

11. Zellenmodul (10) nach Anspruch 9 oder 10, wobei die Öffnung (36) durch ein Schneiden und ein Einwärtsfalten des Metallblechs eingerichtet wird.

12. Zellenmodul (10) nach einem der vorhergehenden Ansprüche, das außerdem eine elektronische Komponente (18) umfasst, die in dem Gehäuse (12) angeordnet ist.

13. Zellenmodul (10) nach Anspruch 12, wobei die elektronische Komponente (18) aus einer Umrichterzelle besteht.

14. Zellenmodul (10) nach Anspruch 12 oder 13, wobei das Zellenmodul (10) mindestens zwei elektronische Komponenten (18) umfasst, die in dem Gehäuse (12) angeordnet sind.

15. Modularer Umrichter, der eine Vielzahl von Zellenmodulen (10) nach einem der vorhergehenden Ansprüche umfasst.

## Revendications

1. Module de cellule (10) pour un convertisseur modulaire, le module de cellule (10) comprenant :
- une enceinte (12) ayant une section de paroi (20) en matériau électriquement conducteur et une ouverture (36) dans la section de paroi (20) ;
- au moins un conduit de refroidissement intérieur (28) pour distribuer un fluide de refroidissement diélectrique vers et/ou à partir d'un composant électronique (18) agencé à l'intérieur de l'enceinte (12) ;
- au moins un conduit de refroidissement extérieur (26) en matériau diélectrique pour distribuer le fluide de refroidissement diélectrique vers ou à partir d'une région à l'extérieur de l'enceinte (12) ; et
- au moins un élément de connexion (34) en matériau électriquement conducteur reliant l'au moins un conduit de refroidissement intérieur (28) à un conduit de refroidissement extérieur respectif (26) pour établir une connexion fluidique entre le composant électronique (18) et la région à l'extérieur de l'enceinte (12) par l'intermédiaire de l'ouverture (36) ;
l'au moins un élément de connexion (34) et la section de paroi (20) étant au même potentiel électrique ; et
l'au moins un élément de connexion (34) étant prévu à l'intérieur et à proximité de la section de paroi (20) de l'enceinte (12).

2. Module de cellule (10) selon la revendication 1, une surface extérieure (44) de l'au moins un élément de connexion (34) étant sensiblement au même niveau qu'une surface intérieure (46) de la section de paroi (20).

3. Module de cellule (10) selon la revendication 1 ou 2, l'au moins un conduit de refroidissement extérieur (26) comprenant une section sensiblement droite connectée à l'élément de connexion (34).

4. Module de cellule (10) selon la revendication 3, une distance (40) entre une surface extérieure (44) de l'au moins un élément de connexion (34) et une surface intérieure (46) de la section de paroi (20) étant inférieure à 10 % de la longueur (38) de la section sensiblement droite de l'au moins un conduit de refroidissement extérieur (26).

5. Module de cellule (10) selon l'une quelconque des revendications précédentes, l'au moins un conduit de refroidissement intérieur (28) étant constitué d'un matériau électriquement conducteur et étant connecté de manière électriquement conductrice à l'enceinte (12).

6. Module de cellule (10) selon la revendication 5, comprenant en outre une structure de support intérieure (16), l'au moins un conduit de refroidissement intérieur (28) étant constitué d'un matériau électriquement conducteur et étant connecté de manière électriquement conductrice à la structure de support intérieure (16).

7. Module de cellule (10) selon la revendication 5 ou 6, l'au moins un élément de connexion (34) étant constitué par une section d'extrémité du conduit de refroidissement intérieur respectif (28).

8. Module de cellule (10) selon l'une quelconque des revendications précédentes, l'au moins un conduit de refroidissement extérieur (26) étant constitué par deux conduits de refroidissement extérieurs (26) entourés par l'ouverture (36) dans la section de paroi (20).

9. Module de cellule (10) selon l'une quelconque des revendications précédentes, la section de paroi (20) étant constituée d'une feuille métallique.

10. Module de cellule (10) selon la revendication 9, l'ouverture (36) étant délimitée par un ou plusieurs plis (48) de la feuille métallique.

11. Module de cellule (10) selon la revendication 9 ou 10, l'ouverture (36) étant établie en coupant et en pliant la feuille métallique vers l'intérieur.

12. Module de cellule (10) selon l'une quelconque des revendications précédentes, comprenant en outre un composant électronique (18) agencé à l'intérieur de l'enceinte (12).

13. Module de cellule (10) selon la revendication 12, le composant électronique (18) étant constitué par une cellule de conversion.

14. Module de cellule (10) selon la revendication 12 ou 13, le module de cellule (10) comprenant au moins deux composants électroniques (18) agencés à l'intérieur de l'enceinte (12).

15. Convertisseur modulaire comprenant une pluralité de modules de cellules (10) selon l'une quelconque des revendications précédentes.
